# FASCICULE DE BREVET EUROPEEN

(11) **EP 3 417 492 B1**
(45) Date de publication et mention de la délivrance du brevet: **11.03.2020**
(21) Numéro de dépôt: 17708865.5
(22) Date de dépôt: 13.02.2017
(51) Int. Cl.: H01L 35/32, G01J 5/12

(54) **DISPOSITIF THERMOÉLECTRIQUE**
THERMOELEKTRISCHE VORRICHTUNG
THERMOELECTRIC DEVICE

(30) Priorité: 18.02.2016 FR 1651336
(43) Date de publication de la demande: 26.12.2018
(73) Titulaire: Centre National de la Recherche Scientifique, 75794 Paris Cedex 16 (FR)
(72) Inventeur: BOURGEOIS, Olivier, 38380 Saint Laurent Du Pont (FR); TAINOFF, Dimitri, 38000 Grenoble (FR); BOURGAULT, Daniel, 75794 Paris Cedex 16 (FR)
(74) Mandataire: IPAZ
(86) Numéro de dépôt international: PCT/FR2017/050324
(87) Numéro de publication internationale: WO 2017/140975

(56) Documents cités:
- EP-A1- 2 887 033
- EP-A2- 1 976 034
- JP-A- 2000 077 729
- US-A- 6 046 398

## Description

### Domaine

La présente demande concerne les dispositifs thermoélectriques, et en particulier un dispositif comprenant des matériaux thermoélectriques de types alternés N et P reliés en série par des liaisons métalliques.

### Exposé de l'art antérieur

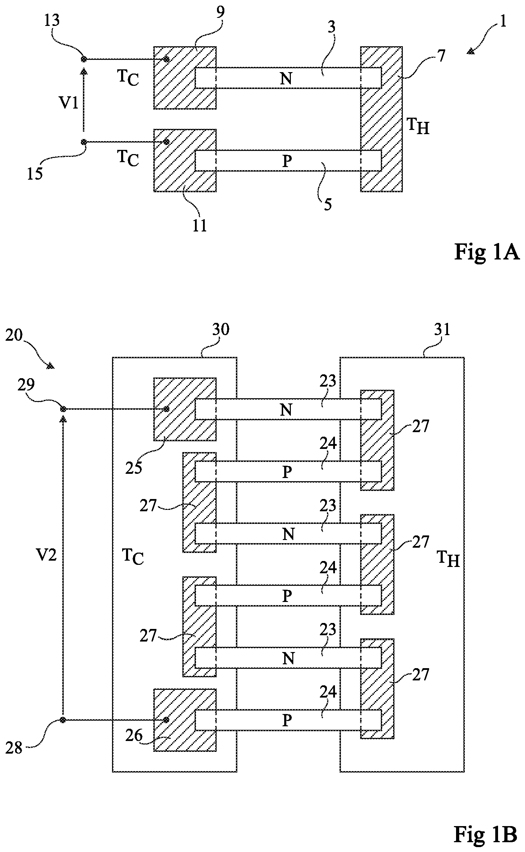

La figure 1A représente un dispositif thermoélectrique 1 à pistes thermoélectriques de types alternés N et P reliées en série par des liaisons métalliques. Le dispositif comprend un ruban semiconducteur 3 dopé de type N et un ruban semiconducteur 5 dopé de type P. Ces rubans constituent des pistes thermoélectriques. Les pistes 3 et 5 sont reliées électriquement en série par une liaison métallique 7 entre deux plots métalliques 9 et 11 dotés de bornes 13 et 15.

Dans un mode de fonctionnement, les plots 9 et 11 sont à une température T_{C} et la liaison métallique 7 est à une température T_{H} supérieure à la température T_{C}. Une tension V1 apparait alors entre les bornes 13 et 15. Le dispositif thermoélectrique 1 peut alors être utilisé comme source de courant ou de tension (thermopile) pour alimenter un circuit électronique autonome. Le dispositif peut aussi être utilisé pour détecter l'écart entre la température des plots et celle de la liaison métallique.

Dans un autre mode de fonctionnement, les contacts 13 et 15 sont reliés à une source d'alimentation, et le passage d'un courant dans les pistes 3 et 5 produit un écart entre la température des plots et celle de la liaison métallique 7. Le dispositif thermoélectrique 1 peut alors être utilisé comme refroidisseur de type Peltier.

La tension produite par le dispositif 1 utilisé comme thermopile lorsque les températures T_{H} et T_{C} ont un écart donné dépend de la nature des matériaux des pistes. On définit la sensibilité thermoélectrique ou coefficient de Seebeck (en V/°C) du matériau d'une piste par la tension qui apparait entre les extrémités de la piste pour une différence donnée de température entre les extrémités. Afin d'augmenter le courant et/ou la tension produite, autrement dit les performances du dispositif, on souhaite augmenter le coefficient de Seebeck et on cherche à diminuer d'une part la résistance électrique des pistes et d'autre part la conduction thermique entre la liaison métallique 7 et les plots 9 et 11.

La figure 1B représente un dispositif thermoélectrique 20 à pistes thermoélectriques 23 et 24 de types alternés N et P reliées en série entre deux plots métalliques 25 et 26 par des liaisons métalliques 27. Les plots 25 et 26 sont dotés de bornes 28 et 29. Les liaisons métalliques 27 qui se succèdent entre les pistes sont alternativement en contact thermique avec un bloc 30 à la température T_{C} et un bloc 31 à la température T_{H}. Une tension V2, liée au nombre de pistes en série, est produite entre les bornes 28 et 29 en fonction de l'écart entre les températures T_{H} et T_{C}.

D'une manière générale, dans un dispositif thermoélectrique à pistes thermoélectriques de types alternés reliées en série par des liaisons métalliques, une chaîne de pistes relie deux plots métalliques en série. Chaque piste de la chaîne relie deux éléments métalliques tels qu'un plot ou une liaison métallique, et les éléments métalliques sont alternativement en contact thermique entre deux blocs.

Diverses structures de dispositifs thermoélectriques ont été proposées. L'article d'A.P. Perez-Marin et al. "Micropower thermoelectric generator from thin Si membranes" publié dans NanoEnergy (2014) 4, 73,80, décrit un dispositif thermoélectrique dans lequel l'un des deux blocs est constitué d'une plateforme suspendue. Les pistes sont en silicium dopé de types alternés N et P. Cette structure, tout comme d'autres structures connues, présente divers problèmes de robustesse et de performances.

Le document EP 2 887 033 A1 décrit un capteur Infra-Rouge (IR) composé de thermocouples ayant des pistes alternées. Les différents thermocouples sont reliés en série au niveau d'une membrane. Le dispositif comprend en outre la membrane qui est suspendue par différents bras. Chaque bras comprend deux pistes qui forment un thermocouple. Les deux pistes sont dopées chacune d'un type différent, N ou P.

On souhaite disposer de dispositifs thermoélectriques robustes ayant des performances améliorées.

### Résumé

Ainsi, un objet d'un mode de réalisation est de pallier tout ou partie des inconvénients décrits ci-dessus.

Ainsi, un mode de réalisation prévoit une cellule thermoélectrique à pistes thermoélectriques de types alternés reliées en série par des liaisons métalliques, comprenant une plateforme suspendue au-dessus d'un support par des bras, la plateforme et les bras étant des parties d'une même couche isolante thermiquement et électriquement, et chaque bras portant une piste thermoélectrique, de manière à ce que des bras portent des pistes thermoélectriques d'un premier type N et des bras portent des pistes thermoélectriques d'un deuxième type P, la cellule thermoélectrique à pistes thermoélectriques comprenant en outre deux plots métalliques disposés sur le support revêtu de la couche isolante de part et d'autre d'une cavité, un des plots étant en contact avec les pistes de type N et l'autre plot étant en contact avec les pistes de type P.

Selon un mode de réalisation, la cellule comprend deux premiers plots métalliques situés sur le support et au moins deux ensembles de pistes thermoélectriques, chacun des ensembles comprenant des pistes thermoélectriques de types alternés reliées en série entre lesdits premiers plots métalliques.

Selon un mode de réalisation, les pistes thermoélectriques sont en tellure de bismuth dopé, lesdits types correspondant à des types de conductivité.

Selon un mode de réalisation, la couche isolante est en oxyde de silicium, en nitrure de silicium ou en oxyde d'aluminium.

Selon un mode de réalisation, le rapport entre une longueur et une largeur de chaque bras est supérieur à 5.

Selon un mode de réalisation, la plateforme a la forme d'un rectangle, deux bras s'étendant à partir d'un côté du rectangle et deux bras s'étendant à partir du côté opposé, des pistes thermoélectriques d'un même type étant disposées sur des bras situés d'un même côté du rectangle.

Selon un mode de réalisation, la cellule comprend en outre un revêtement absorbant disposé sur la plateforme.

Un mode de réalisation prévoit un dispositif thermoélectrique comprenant une pluralité de cellules thermoélectriques disposées en matrice et ayant un support commun, les cellules thermoélectriques de chaque colonne de la matrice étant connectées en série entre des deuxièmes plots métalliques.

Un mode de réalisation prévoit une thermopile comprenant un dispositif thermoélectrique.

Selon un mode de réalisation, les plateformes sont recouvertes d'un matériau absorbant destiné à capter un rayonnement solaire, le support commun étant destiné à être en contact thermique avec une source froide.

Selon un mode de réalisation, les plateformes sont sous vide.

Selon un mode de réalisation, les plateformes sont en contact avec l'air ambiant, le support commun étant destiné à être en contact thermique avec une source chaude.

Un mode de réalisation prévoit un bolomètre comprenant un dispositif thermoélectrique, le dispositif étant relié à un circuit de détection, les plateformes du dispositif étant recouvertes d'un revêtement absorbant une longueur d'onde choisie, le support commun étant destiné à être en contact thermique avec une source froide.

Un mode de réalisation prévoit un refroidisseur comprenant une cellule thermoélectrique ou un dispositif thermoélectrique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B représentent des dispositifs thermoélectriques à pistes thermoélectriques de types alternés reliées en série par des liaisons métalliques ;
les figures 2A à 2C illustrent de manière schématique un mode de réalisation d'un dispositif thermoélectrique ;
la figure 3 est une vue de dessus schématique d'un mode de réalisation d'un dispositif thermoélectrique ; et
les figures 4A à 7A, 4B à 7B, 6C et 7C illustrent des étapes d'un procédé de fabrication d'un dispositif thermoélectrique.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. Dans la description qui suit, lorsque l'on fait référence à des qualificatifs de position relative, tels que le terme "au-dessus", "sur" et "sous", il est fait référence à l'orientation de l'élément concerné dans les vues en coupe concernées.

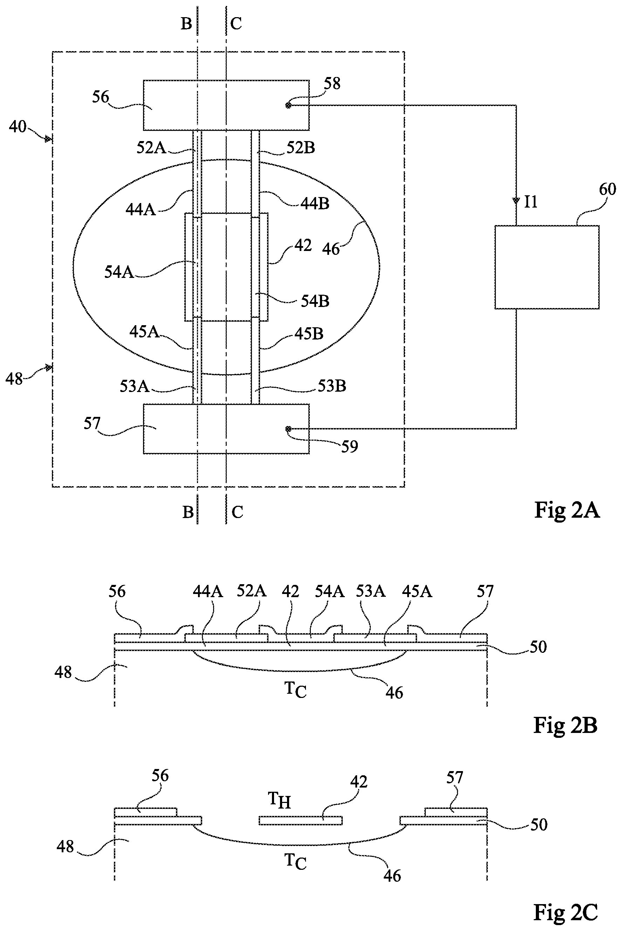

Les figures 2A à 2C illustrent de manière schématique un mode de réalisation d'un dispositif thermoélectrique 40. La figure 2A est une vue de dessus et les figures 2B et 2C sont des vues en coupe selon des plans parallèles B-B et C-C.

Le dispositif 40 comprend une plateforme rectangulaire 42 suspendue par quatre bras 44A, 44B, 45A, 45B au-dessus d'une cavité 46 située dans une face d'un support 48. Les bras 44A et 44B s'étendent à partir d'un côté de la plateforme 42 et se trouvent dans le prolongement des bras 45A et 45B qui s'étendent à partir du côté opposé de la plateforme. Les bras et la plateforme 42 sont des portions d'une même couche isolante 50 qui recouvre aussi les parties du support 48 entourant la cavité 46. Le matériau de la couche isolante 50 est un isolant thermique, c'est-à-dire que sa conductivité thermique est par exemple inférieure à 5 W.m⁻¹.K⁻¹, et est aussi un isolant électrique.

Chacun des bras porte une piste thermoélectrique. Les bras 44A et 44B portent des pistes thermoélectriques 52A et 52B d'un premier type. Les bras 45A et 45B portent des pistes thermoélectriques 53A et 53B d'un deuxième type. Les pistes 52A et 53A situées dans le prolongement l'une de l'autre sont reliées par une liaison métallique 54A située sur la plateforme. Les pistes 52B et 53B sont reliées par une liaison métallique 54B située sur la plateforme. Des plots métalliques 56 et 57 sont disposés sur le support revêtu de la couche isolante 50 de part et d'autre de la cavité 46, le plot 56 étant en contact avec les pistes 52A et 52B et le plot 57 étant en contact avec les pistes 53A et 53B. Ainsi, les pistes 52A et 53A sont de types alternés et sont reliées en série entre les plots 56 et 57 par la liaison métallique 54A. Les pistes 52B et 53B sont reliées en série de manière similaire entre les plots métalliques 56 et 57. La couche 50 isole électriquement les plots du support, mais est suffisamment mince pour mettre les plots et le support en contact thermique.

Dans un mode d'utilisation du dispositif 40, le support 48 du dispositif est maintenu à une température T_{C}. La plateforme est portée à une température T_{H} différente de T_{C}. Les plots métalliques 56 et 57 sont couplés par l'intermédiaire de contacts 58 et 59 à un circuit d'utilisation d'un courant I1 provenant des plots 56 et 57 et généré par le dispositif 40.

Dans le dispositif 40, chacune des pistes 52A, 52B, 53A et 53B est portée mécaniquement par un bras. La tenue mécanique de la structure est assurée par les bras car les caractéristiques mécaniques des pistes seules pourraient être insuffisantes pour suspendre la plateforme de manière robuste.

Ainsi, le choix du matériau des pistes peut avantageusement être fait indépendamment des propriétés mécaniques de ce matériau. On peut par exemple choisir de former les pistes en un matériau tel que le tellure de bismuth dont la conductivité électrique, la résistivité thermique et la sensibilité thermoélectrique sont optimales à température ambiante. Dans le cas de pistes en tellure de bismuth, les pistes du premier type sont dopées de type N, par exemple par du sélénium, et les pistes du deuxième type sont dopées de type P, par exemple par de l'antimoine. De manière générale, on peut utiliser pour les pistes tout matériau dont la conductivité électrique, la résistivité thermique et le coefficient de Seebeck sont adaptés aux températures de fonctionnement du dispositif.

La plateforme 42 étant suspendue, les fuites thermiques entre la plateforme et le support 48 se font essentiellement par l'intermédiaire des bras et des pistes. Or, les bras sont en un matériau thermiquement isolant et les pistes sont très minces. De ce fait la différence entre les températures T_{H} et T_{C} se retrouve en quasi-totalité entre les extrémités des pistes, ce qui permet au dispositif 40 d'être particulièrement performant.

On notera que le dispositif 40 comprend deux chaînes de pistes thermoélectriques, 52A et 53A d'une part et 52B et 53B d'autre part. Les plots sont reliés parallèlement par les deux chaînes et de ce fait, la résistance qui s'oppose au passage d'un courant est faible, ce qui permet l'obtention d'un courant élevé. De plus, dans le cas où une piste de l'une des chaînes se trouve endommagée, l'autre chaîne de pistes reste fonctionnelle et le dispositif peut tout de même fournir un courant.

A titre d'exemple, le support 48 est en silicium. Les pistes peuvent avoir des épaisseurs comprises entre 50 et 500 nm. La couche isolante 50 peut être par exemple en nitrure de silicium, en oxyde de silicium ou en oxyde d'aluminium. La couche isolante 50 peut avoir une épaisseur comprise entre 100 et 300 nm. A titre d'exemple, les côtés de la plateforme ont des dimensions comprises entre 5 et 200 µm. A titre d'exemple, la dimension des petits côtés des bras, ou largeur des bras, peut être comprise entre 0,5 et 3 µm. Le rapport entre la dimension des grands côtés des bras, ou longueur des bras, et la largeur des bras peut être supérieur à 5. A titre d'exemple, les liaisons métalliques 54A et 54B et les plots métalliques 56 et 57 sont en nickel, en palladium ou en titane-or. A titre d'exemple, les liaisons métalliques et les plots métalliques ont une épaisseur comprise entre 50 et 500 nm. Cette épaisseur dépend de l'épaisseur des couches thermoélectriques.

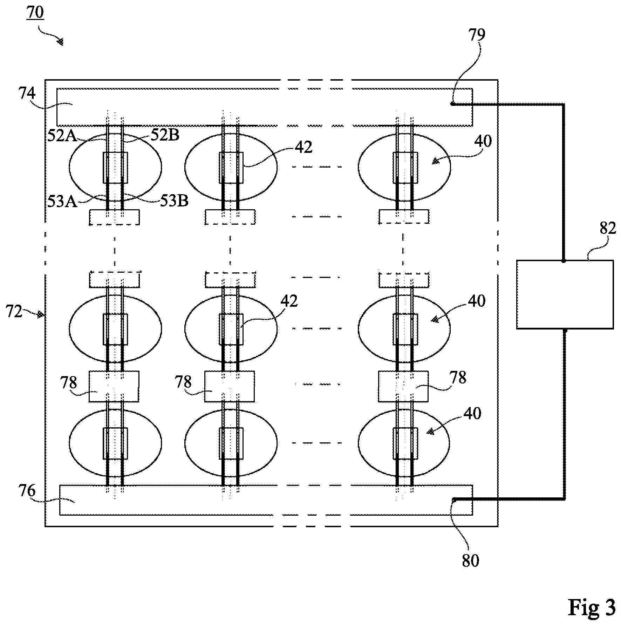

La figure 3 est une vue de dessus schématique d'un mode de réalisation d'un dispositif thermoélectrique 70 encore plus robuste que celui décrit précédemment et ayant des performances plus élevées.

Le dispositif thermoélectrique 70 comprend un ensemble de cellules thermoélectriques 40 dont chacune est un dispositif du type décrit en relation avec les figures 2A à 2C. Les cellules 40 sont formées sur un support commun 72 et disposées en matrice entre deux plots métalliques allongés 74 et 76. Les cellules 40 sont orientées de sorte que les pistes 52A et 52B de chaque cellule s'étendent à partir de la plateforme 42 en direction du plot allongé 74. Les cellules de chaque colonne sont reliées en série par des plots 78. Les colonnes en parallèle relient électriquement les plots 74 et 76.

Dans un mode de fonctionnement, les plots 74 et 76 du dispositif sont couplés par des contacts 79 et 80 à un circuit de régulation 82. Les plateformes 42 et le support 72 sont mis à des températures T_{C} et T_{H} différentes.

Dans le cas où une cellule du dispositif 70 est détériorée, seule la colonne comprenant la cellule défectueuse peut ne plus être en état de fournir un courant. Les autres colonnes continuent de fonctionner normalement. Ainsi, le dispositif 70 est résistant à des pannes.

Dans une variante, des plots 78 appartenant à des colonnes différentes et situés à des mêmes distances des plots allongés 74 et 76 sont connectés entre eux. Ainsi, dans le cas où une cellule du dispositif selon cette variante est détériorée, les autres cellules continuent de fonctionner normalement et le dispositif est ainsi particulièrement résistant à des pannes.

En fonctionnement, les courants produits par les colonnes s'ajoutent. De ce fait, le dispositif 70 produit un courant élevé. Dans chaque colonne, les tensions fournies par les cellules s'ajoutent. Ainsi, selon un avantage important, on peut ajuster la tension produite par le dispositif 70 par le choix du nombre de cellules de chaque colonne, et on peut ajuster le courant produit par le dispositif par le choix du nombre de colonnes. On peut ainsi adapter l'impédance du dispositif beaucoup plus facilement qu'avec une structure classique.

A titre d'exemple, une matrice occupant une surface de 1 cm² peut comprendre entre 20 et 500 colonnes, par exemple 300 colonnes. Chaque colonne peut comprendre entre 10 et 300 cellules, par exemple 20 cellules.

Dans un mode d'utilisation du dispositif thermoélectrique 70, les plateformes 42 sont recouvertes d'un matériau tel qu'une résine noire adapté à absorber un rayonnement tel que le rayonnement solaire. Le support 72 est disposé sur un socle maintenu à une température T_{C} par une source froide. A titre d'exemple, on connecte au circuit de régulation 82 une batterie d'un dispositif électronique autonome. La face du dispositif 70 où les plateformes 42 sont situées est placée au soleil. Une élévation de la température des plateformes 42 par rapport à la température du socle provoque la circulation d'un courant. Le dispositif constitue ainsi une thermopile propre à charger la batterie. Des concentrateurs optiques peuvent être disposés au-dessus des plateformes afin d'augmenter l'échauffement des plateformes et afin d'obtenir un courant plus élevé. De plus, les plateformes peuvent être mises sous vide, c'est-à-dire placées dans un environnement dans lequel des gaz résiduels sont à une pression réduite permettant de limiter les transferts thermiques.

Dans un autre mode d'utilisation, le dispositif 70 est disposé sur un socle maintenu à une température T_{H} par une source chaude et le circuit de régulation 82 est relié à une batterie. Les plateformes 42 sont en contact avec un flux d'air ambiant, provoqué par exemple par une convection naturelle. Une diminution de la température des plateformes 42 par rapport à la température du socle provoque un courant propre à charger la batterie.

Dans un autre mode d'utilisation, le dispositif 70 est disposé sur un socle maintenu à une température T_{C} par une source froide et le circuit de régulation 82 est remplacé par un circuit de détection du courant produit par le dispositif. Les plateformes 42 sont recouvertes d'un matériau absorbant un rayonnement de longueur d'onde choisie, par exemple un rayonnement infrarouge. L'ensemble obtenu constitue alors un bolomètre. En effet, lorsque les plateformes sont exposées à un rayonnement infrarouge, le rayonnement est absorbé par le matériau et la température des plateformes s'élève. On note qu'une cellule 40 unique peut suffire pour obtenir un bolomètre, de telles cellules 40 disposées en matrice pouvant alors être utilisées comme détecteur infrarouge à résolution spatiale.

Dans un mode d'utilisation pour la détection de la présence d'un gaz, des premier et deuxième dispositifs 70 identiques sont disposés sur un socle refroidi en vis-à-vis d'une source d'un rayonnement optique. Les plateformes du premier dispositif 70 sont recouvertes d'un revêtement adapté à absorber sélectivement le rayonnement optique, et les plateformes du deuxième dispositif absorbent moins le rayonnement optique. La longueur d'onde du rayonnement optique correspond à une raie d'absorption du gaz. Les plots des dispositifs sont connectés à un circuit de comparaison des tensions ou des courants produits par les deux dispositifs. Le circuit de comparaison détecte ainsi la présence du gaz.

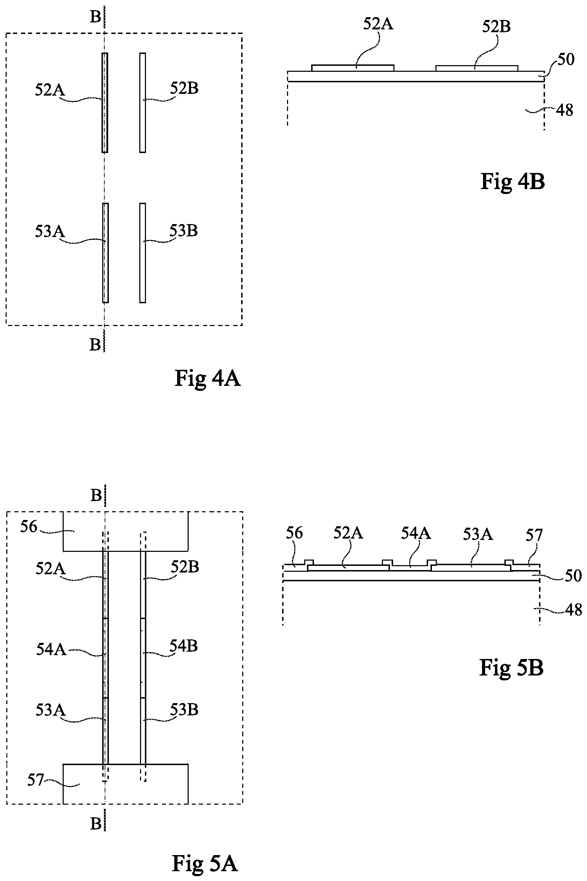

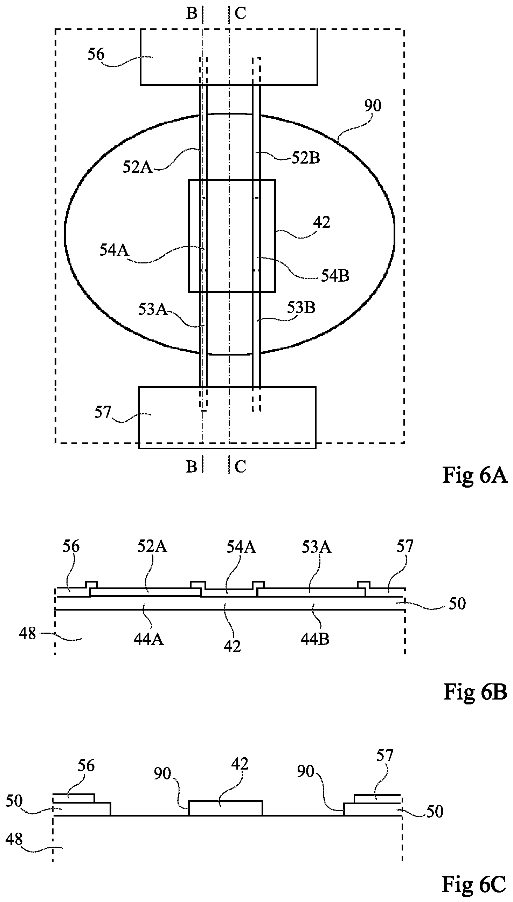

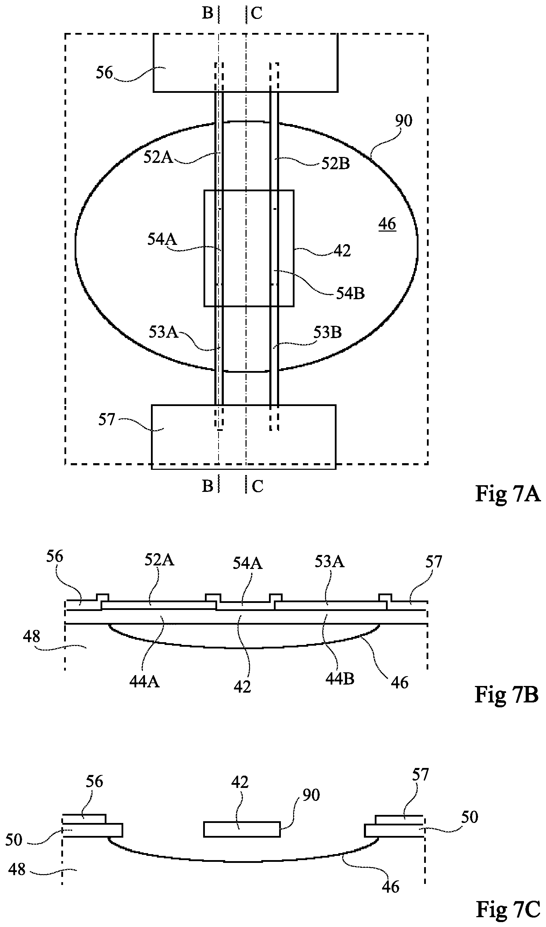

Les figures 4A à 7A, 4B à 7B, 6C et 7C illustrent des étapes d'un procédé de fabrication d'une cellule thermoélectrique 40. Les figures 4A à 7A sont des vues schématiques de dessus, les figures 4B à 7B sont des vues schématiques en coupe selon un plan B-B et les figures 6C et 7C sont des vues schématiques en coupe selon un plan C-C.

A l'étape illustrée en figures 4A et 4B, on a formé quatre pistes 52A, 52B, 53A et 53B dans une disposition et des matériaux identiques à ceux des quatre pistes du dispositif 40. Les pistes s'étendent sur la surface d'une couche isolante 50 de nitrure de silicium recouvrant un support 48 de silicium. A titre d'exemple, les pistes sont réalisées par une technique telle que celle connue sous le nom anglais de "lift-off". L'ensemble de la structure, s'il y a lieu, est soumis à un recuit.

A l'étape illustrée en figures 5A et 5B, on forme des liaisons métalliques 54A et 54B qui relient les pistes en deux ensembles de deux pistes en série. Un plot métallique 56 est formé sur les extrémités des pistes 52A et 52B, et un autre plot métallique 57 est déposé sur les extrémités des pistes 53A et 53B.

A l'étape illustrée en figures 6A à 6C, des ouvertures 90 sont gravées dans la couche isolante 50. Les ouvertures 90 délimitent une plateforme 42 et des bras 44A, 44B, 45A et 45B de la couche isolante 50 disposés sous les pistes 52A, 52B, 53A et 53B et connectés à la plateforme. A titre d'exemple, les ouvertures 90 sont gravées par un plasma à base d'hexafluorure de soufre à travers un masque non représenté.

A l'étape illustrée en figures 7A à 7C, les portions du support situées sous les bras et sous la plateforme 42 sont retirées à partir des ouvertures 90 pour former une cavité 46. Ces portions du support peuvent être retirées par gravure isotrope en phase gazeuse. A titre d'exemple, le support de silicium est gravé par du difluorure de xénon.

Des modes de réalisation particuliers ont été décrits. Diverses variantes et modifications apparaîtront à l'homme de l'art. En particulier, bien que, dans les modes de réalisation décrits ci-dessus, chaque plateforme soit suspendue par quatre bras, chaque plateforme peut être suspendue par tout nombre pair de bras. L'essentiel est que chaque bras porte une piste et que des pistes de types alternés soient reliées en série entre deux plots métalliques par des liaisons métalliques. De cette manière, chaque piste relie deux éléments métalliques dont l'un est situé sur la plateforme et l'autre est situé sur le support. Les éléments métalliques se trouvent ainsi alternativement sur la plateforme et sur le support.

Bien que, dans les modes de réalisation décrits, la cellule 40 comprenne deux chaînes de pistes reliées en série entre des plots métalliques, d'autres modes de réalisation peuvent comprendre tout autre nombre différent de chaînes de pistes reliées en série entre les plots.

Bien que, dans les modes de réalisation décrits, la plateforme de la cellule 40 ait une forme rectangulaire, d'autres formes sont possibles, par exemple une forme circulaire.

Bien que, dans les modes de réalisation décrits, la plateforme et les bras de la cellule 40 soient en nitrure de silicium, en oxyde de silicium ou en oxyde d'aluminium, la plateforme et les bras peuvent être en tout autre matériau isolant thermique et électrique.

Bien que, dans des modes de réalisation décrits, la cellule 40 soit formée sur un support en silicium, le support peut être en tout matériau dont la conductivité thermique est suffisante pour que, lorsque la plateforme et le support sont à des températures différentes, la quasi-totalité de la différence entre ces températures se retrouve entre la plateforme et des éléments métalliques situés sur le support.

## Revendications

1. Cellule thermoélectrique à pistes thermoélectriques (52A, 52B, 53A, 53B) de types alternés reliées en série par des liaisons métalliques (54A, 54B), comprenant une plateforme (42) suspendue au-dessus d'un support par des bras (44A, 44B, 45A, 45B), la plateforme et les bras étant des parties d'une même couche (50) isolante thermiquement et électriquement, et chaque bras portant une piste thermoélectrique, de manière à ce que des bras(44A, 44B) portent des pistes thermoélectriques d'un premier type N (52A, 52B) et des bras (45A, 45B) portent des pistes thermoélectriques d'un deuxième type P (53A, 53B), la cellule thermoélectrique à pistes thermoélectriques (52A, 52B, 53A, 53B) comprenant en outre deux plots métalliques (56, 57) disposés sur le support revêtu de la couche isolante (50) de part et d'autre d'une cavité (46), un des plots (56) étant en contact avec les pistes de type N (52A, 52B) et l'autre plot (57) étant en contact avec les pistes de type P (53A, 53B).

2. Cellule selon la revendication 1, dans laquelle les pistes thermoélectriques (52A et 53A, 52B et 53B) sont en tellure de bismuth dopé, lesdits types correspondant à des types de conductivité.

3. Cellule selon la revendication 1 ou 2, dans laquelle la couche isolante (50) est en oxyde de silicium, en nitrure de silicium ou en oxyde d'aluminium.

4. Cellule selon l'une quelconque des revendications 1 à 3, dans laquelle le rapport entre une longueur et une largeur de chaque bras (44A, 44B, 45A, 45B) est supérieur à 5.

5. Cellule selon l'une quelconque des revendications 1 à 4, comprenant en outre un revêtement absorbant disposé sur la plateforme.

6. Dispositif thermoélectrique comprenant une pluralité de cellules thermoélectriques selon l'une quelconque des revendications 1 à 5 disposées en matrice et ayant un support commun, les cellules thermoélectriques de chaque colonne de la matrice étant connectées en série entre des deuxièmes plots métalliques (74, 76).

7. Thermopile comprenant un dispositif selon la revendication 6.

8. Thermopile selon la revendication 7, dans laquelle les plateformes (42) sont recouvertes d'un matériau absorbant (84) destiné à capter un rayonnement solaire, le support commun étant destiné à être en contact thermique avec une source froide.

9. Thermopile selon la revendication 8, dans laquelle les plateformes (42) sont sous vide.

10. Thermopile selon la revendication 7, dans laquelle les plateformes (42) sont en contact avec l'air ambiant, le support commun étant destiné à être en contact thermique avec une source chaude.

11. Bolomètre comprenant un dispositif selon la revendication 6, le dispositif étant relié à un circuit de détection, les plateformes du dispositif étant recouvertes d'un revêtement absorbant une longueur d'onde choisie, le support commun étant destiné à être en contact thermique avec une source froide.

12. Refroidisseur comprenant une cellule selon l'une quelconque des revendications 1 à 5 ou un dispositif selon la revendication 6.

## Patentansprüche

1. Thermoelektrische Zelle mit thermoelektrischen Bahnen (52A, 52B, 53A, 53B) abwechselnder Art, die durch Metallverbindungen (54A, 54B) in Reihe geschaltet sind, enthaltend eine Plattform (42), die über Arme (44A, 44B, 45A, 45B) oberhalb eines Trägers aufgehängt ist, wobei die Plattform und die Arme Teile derselben thermisch und elektrisch isolierenden Schicht (50) sind und jeder Arm eine thermoelektrische Bahn trägt, so dass die Arme (44A, 44B) thermoelektrische Bahnen eines ersten Typs N (52A, 52B) und die Arme (45A, 45B) thermoelektrische Bahnen eines zweiten Typs P (53A, 53B) tragen, wobei die thermoelektrische Zelle mit thermoelektrischen Bahnen (52A, 52B, 53A, 53B) ferner zwei metallische Kontaktstücke (56, 57) enthält, die an dem mit der Isolierschicht (50) überzogenen Träger zu beiden Seiten eines Hohlraums (46) angeordnet sind, wobei eines der Kontaktstücke (56) mit den Bahnen des Typs N (52A, 52B) und das andere Kontaktstück (57) mit den Bahnen des Typs P (53A, 53B) in Kontakt steht.

2. Zelle nach Anspruch 1, wobei die thermoelektrischen Bahnen (52A und 53A, 52B und 53B) aus dotiertem Bismuttellurid bestehen, wobei die genannten Typen Leitfähigkeitstypen entsprechen.

3. Zelle nach Anspruch 1 oder 2, wobei die Isolierschicht (50) aus Siliziumoxid, Siliziumnitrid oder Aluminiumoxid besteht.

4. Zelle nach einem der Ansprüche 1 bis 3, wobei das Verhältnis zwischen einer Länge und einer Breite jedes Arms (44A, 44B, 45A, 45B) größer als 5 ist.

5. Zelle nach einem der Ansprüche 1 bis 4, ferner enthaltend eine auf der Plattform angeordnete absorbierende Beschichtung.

6. Thermoelektrische Vorrichtung mit einer Vielzahl von thermoelektrischen Zellen nach einem der Ansprüche 1 bis 5, die in einer Matrix angeordnet sind und einen gemeinsamen Träger haben, wobei die thermoelektrischen Zellen jeder Spalte der Matrix zwischen zweiten metallischen Kontaktstücken (75, 76) in Reihe geschaltet sind.

7. Thermosäule, enthaltend eine Vorrichtung nach Anspruch 6.

8. Thermosäule nach Anspruch 7, wobei die Plattformen (42) mit einem absorbierenden Material (84) bedeckt sind, das dazu bestimmt ist, eine Sonneneinstrahlung abzufangen, wobei der gemeinsame Träger dazu bestimmt ist, in thermischem Kontakt mit einer Kältequelle zu stehen.

9. Thermosäule nach Anspruch 8, wobei die Plattformen (42) unter Vakuum stehen.

10. Thermosäule nach Anspruch 7, wobei die Plattformen (42) in Kontakt mit der Umgebungsluft stehen, wobei der gemeinsame Träger dazu bestimmt ist, in thermischem Kontakt mit einer Wärmequelle zu stehen.

11. Bolometer mit einer Vorrichtung nach Anspruch 6, wobei die Vorrichtung mit einer Erfassungsschaltung verbunden ist, die Plattformen der Vorrichtung mit einer Beschichtung bedeckt sind, die eine ausgewählte Wellenlänge absorbiert, und der gemeinsame Träger dazu bestimmt ist, in thermischem Kontakt mit einer Kältequelle zu stehen.

12. Kühler, umfassend eine Zelle nach einem der Ansprüche 1 bis 5 oder eine Vorrichtung nach Anspruch 6.

## Claims

1. Thermoelectric cell having thermoelectric tracks (52A, 52B, 53A, 53B) of alternating types connected in series by metallic connections (54A, 54B), comprising a platform (42) suspended over a substrate by arms (44A, 44B, 45A, 45B), the platform and the arms being parts of a same thermally and electrically insulating layer (50), and each arm supporting a thermoelectric track, so that arms (44A, 44B) support thermoelectric tracks (52A, 52B) of a first type N, and arms (45A, 45B) support thermoelectric tracks (53A and 53B) of a second type P, the thermoelectric cell having thermoelectric tracks (52A, 52B, 53A, 53B)further comprising two metallic contacts (56,57) located on the substrate covered with insulating layer (50) on either side of cavity (46), one of contacts (56) being in contact with tracks (52A, 52B) of type N and one of contacts (57) being in contact with tracks (53A and 53B) of type P.

2. Cell as defined in claim 1, in which the thermoelectric tracks (52A and 53A, 52B and 53B) are made of doped bismuth telluride, the types corresponding to types of conductivity.

3. Cell as defined in claim 1 or 2, in which the insulating layer (50) is made of silicon oxide, silicon nitride or aluminium oxide.

4. Cell as defined in any of the claims 1 to 3, in which the ratio between a length and a width of each arm (44A, 44B, 45A, 45B) is greater than 5.

5. Cell as defined in any of the claims 1 to 4, also including an absorbent coating placed on the platform.

6. Thermoelectric device comprising a plurality of thermoelectric cells as defined in any of the claims 1 to 5, arranged in a matrix and having a common substrate, the thermoelectric cells of each column of the matrix being connected in series between second metallic contacts (74, 76).

7. Thermopile comprising a device as defined in claim 6.

8. Thermopile as defined in claim 7, in which the platforms (42) are covered with an absorbent material (84) designed to absorb solar radiation, the common substrate being designed to be in thermal contact with a cold source.

9. Thermopile as defined in claim 8, in which the platforms (42) are under vacuum.

10. Thermopile as defined in claim 7, in which the platforms (42) are in contact with the surrounding air, the common substrate being designed to be in thermal contact with a heat source.

11. Bolometer comprising a device as defined in claim 6, the device being connected to a sensing circuit, the platforms of the device being covered with a coating that absorbs a selected wavelength, the common substrate being designed to be in thermal contact with a cold source.

12. Cooler comprising a cell as defined in any of the claims 1 to 5 or a device as defined in claim 6.
